Europäisches Patentamt

European Patent Office

Office européen des brevets

(19)

(11) Publication number: **0 376 568**
**A2**

(12) **EUROPEAN PATENT APPLICATION**

(21) Application number: **89313208.4**

(22) Date of filing: **18.12.89**

(51) Int. Cl.5: **H01L 27/112, H01L 21/82**

(30) Priority: **27.12.88 US 290493**

(43) Date of publication of application:
**04.07.90 Bulletin 90/27**

(84) Designated Contracting States:
**DE FR GB IT NL SE**

(71) Applicant: **TEXAS INSTRUMENTS INCORPORATED**
**13500 North Central Expressway**
**Dallas Texas 75265(US)**

(72) Inventor: **Jones, Andrew D.**
**2808 Forest Grove**
**Richardson TX 75080(US)**
Inventor: **Banzhaf, Walter H.**
**1911 Linda Lane**
**Richardson TX 75081(US)**
Inventor: **Drummond, John D.**
**1700 Skyview**
**Wylie, TX 75098(US)**

(74) Representative: **Abbott, David John et al**
**Abel & Imray Northumberland House 303-306**
**High Holborn**
**London, WC1V 7LH(GB)**

(54) **Read-only memory cell and method of forming same.**

(57) A read-only memory cell (70) is formed at a face (72) of a semiconductor layer (74) having a first conductivity type. A bit line region (54) is formed in the semiconductor layer (74) to be of a second conductivity type. A bit line conductor (44) is coupled to the bit line region (54). A first voltage source region (84) is formed in the semiconductor layer (74) to be of the second conductivity type and is coupled to a source of a first voltage ($V_{dd}$) representative of a first bit value. A first potential channel region (80) is disposed at the face (72) between the bit line region (54) and the first voltage source region (84). A second voltage source region (56) is formed in the semiconductor layer (74) to be of the second conductivity type and is coupled to a source of a second voltage ($V_{ss}$) representative of a second bit value. A second potential channel region (82) is disposed at the face (72) between the bit line region (54) and the second voltage source region (56). A gate insulator layer (76) is formed on the face (72). A word line conductor (42a) is formed on the gate insulator layer such that a predetermined voltage thereon will render a preselected one (82) of the potential channel regions (80, 82) conductive. A thick insulator layer (77) deselects the non-selected potential channel region (80) and prevents the formation of a transistor thereacross.

FIG. 3b

EP 0 376 568 A2

## READ-ONLY MEMORY CELL AND METHOD FOR FORMING SAME

### TECHNICAL FIELD OF THE INVENTION

This invention relates in general to read-only memory cells and arrays, and more particularly to static low-power read-only memory cell arrays formed with field-effect transistors.

### BACKGROUND OF THE INVENTION

Conventional metal/oxide/semiconductor (MOS) read-only memory designs use a single transistor as a storage element for each cell. This single transistor is addressed by a word line coupled to its gate and a data bit is read out on a bit line tied to a drain of the transistor. In a clocked read-only memory (ROM), the bit line is precharged to a high voltage. In a static ROM, the bit line is pulled high with an active or passive load.

Conventional ROMs are programmed by selectively omitting the transistor in the cell. Hence, when the bit line connected to the cell is read, the bit line will stay high as no current path is formed between ground and the bit line. The ROM is programmed low by the presence of a transistor in the cell. Responsive to the presence of the transistor, the bit line is pulled low by the transistor when the word line goes high.

Clocked ROMs have an advantage in that their static power dissipation is low. However, clocked ROMs require clocks and special timing, as their name implies. Static ROMs eliminate the need for clocks, but suffer a disadvantage in their dissipation of DC power. A need has therefore arisen for a read-only memory cell and array that both has low static power dissipation and avoids clocks and special timing.

### SUMMARY OF THE INVENTION

According to one aspect of the present invention, a read-only memory cell comprises a transistor having a current path and a control electrode for controlling the conductance of the current path. A word line is coupled to the control electrode. A first end of this current path is coupled to a bit line. The cell has available to it a first voltage source representative of a first bit value, and a second voltage source representative of a second bit value. A second end of the transistor current path is coupled to a preselected one of the first and second voltage sources, such that a selected one of the bit values may be read from the bit line when the current path is rendered conductive.

According to another aspect of the invention, the read-only memory cell is formed at a face of a semiconductor layer having a first conductivity type. The cell includes a bit line region of a second conductivity type formed in the semiconductor layer. A bit line is coupled to the bit line region. A first voltage source region is formed in the semiconductor layer to be of the second conductivity type and is coupled to a source of voltage representative of a first bit value. A first potential channel region is disposed at the face of the semiconductor layer between the bit line region and the first voltage source region. A second voltage source region is formed in the semiconductor layer to be of the second conductivity type, and is coupled to a source of voltage representative of a second bit value. A second potential channel region is disposed at the face of the semiconductor layer between the bit line region and the second voltage source region. The first and second voltage source regions are spaced from each other. A word line conductor is insulatively disposed adjacent to at least a preselected, programmed one of the potential channel regions such that a predetermined voltage thereon will render the selected one of the potential channel regions conductive. Preferably, the non-selected potential channel region is masked with a thick insulator layer, such that it cannot be rendered conductive.

The first and second voltage sources may typically comprise $V_{dd}$ and $V_{ss}$. A principal advantage of the invention is obtained from the alternative connection of a transistor from the bit line to one of these two voltage sources. Since $V_{dd}$ is supplied at the cell, no clocking circuitry or timing is necessary. Since no pull-up prior to sensing of the bit line is required, static power dissipation is also eliminated.

### BRIEF DESCRIPTION OF THE DRAWINGS

Further aspects of the invention and their advantages will be discerned in the following detailed description when taken in conjunction with the appended drawings, in which like reference numbers indicate like features throughout the drawings, and wherein:

FIGURE 1 is a simplified schematic electrical circuit diagram of a clocked read-only memory array according to the prior art;

FIGURE 2 is a simplified schematic electrical circuit diagram of a read-only memory array according to the invention;

FIGURE 3a is a highly magnified schematic sectional view of a semiconductor layer showing beginning steps of a ROM cell fabrication process according to the invention;

FIGURE 3b is a sectional view corresponding to FIGURE 3a and showing remaining steps of a ROM cell fabrication process according to the invention;

FIGURE 4 is a plan view of the ROM cell showing in FIGURE 3b, with the view of FIGURE 3b taken substantially along line 3b-3b of FIGURE 4;

FIGURE 5 is a highly magnified sectional view of a contact-programmable ROM cell according to the invention;

FIGURE 6 is a schematic plan view of the cell shown in FIGURE 5, FIGURE 5 being a section taken substantially along line 5-5 of FIGURE 6;

FIGURE 7 is a highly magnified sectional view of a via-programmable ROM cell according to the invention; and

FIGURE 8 is a schematic plan view of the cell shown in FIGURE 7, FIGURE 7 being a section taken substantially along line 7-7 of FIGURE 8.

## DETAILED DESCRIPTION OF THE INVENTION

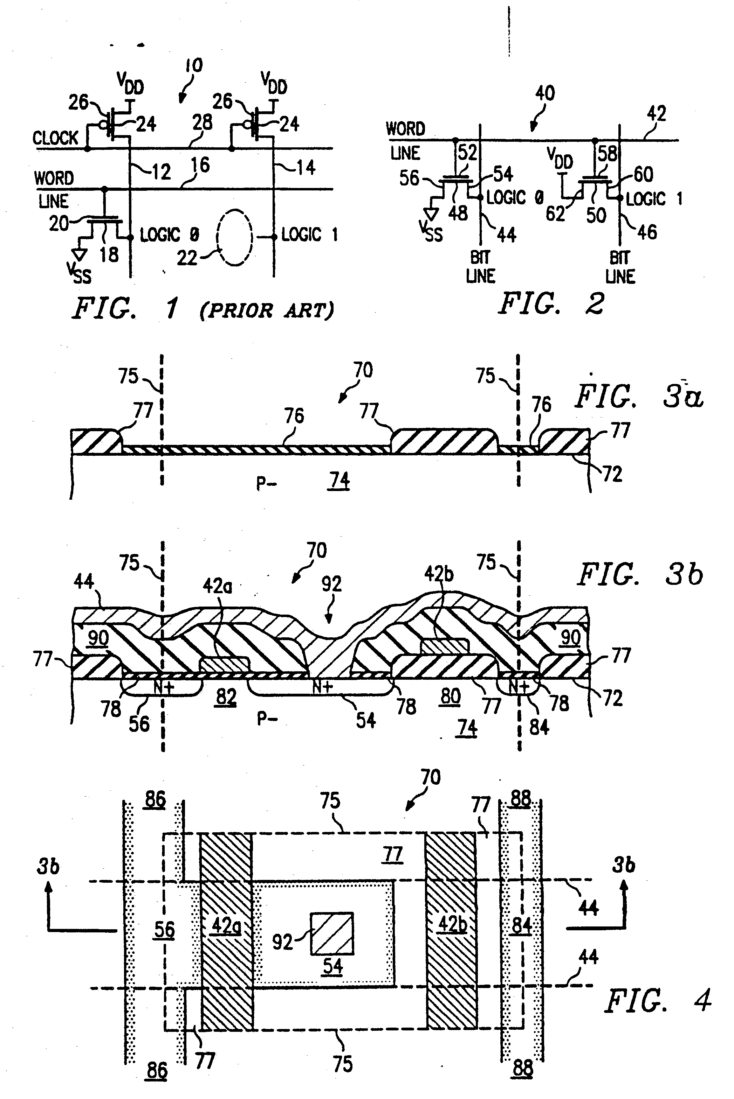

FIGURE 1 illustrates a clocked ROM 10 according to the prior art. The conventional array 10 is formed in a matrix of rows and columns, with a plurality of bit lines 12 and 14 (only two shown for the sake of simplicity) in respective columns and a plurality of word lines (only one shown at 16) in respective rows. To represent a logic "0", a transistor 18 is formed at the intersection of a bit line 12 and a word line 16. A gate 20 of the transistor is connected to the word line 16 to control the conductance of its current path. The ends of the current path of the transistor 18 are respectively connected to the bit line 12 and $V_{ss}$. Where a logic "1" is desired to be represented, a memory cell, as represented by a dashed oval 22, will be formed at the intersection of a word line 16 and a bit line 14 without any transistor.

Each bit line 12 and 14 has an end thereof coupled to an end of a current path of a p-channel field effect transistor 24. A gate 26 of each clocking transistor 24 is connected to a clock line 28. The source of p-channel transistors 24 are connected to $V_{dd}$. In operation, a low-going pulse will be generated on clock line 28, in turn connecting $V_{dd}$ to the bit lines 12 and 14 and precharging them to substantially $V_{dd}$. The word line 16 is then actuated with a high signal. The memory cell transistor 18 is then rendered conductive, and the bit line 12 will be discharged to a logic zero. Since no transistor is formed at cell 22, the bit line 14 will stay at a high voltage to represent a logic one.

This clocked ROM has the disadvantage of requiring the p-channel clocking transistor 24, clock line 28 and timing circuitry (not shown) to precharge the bit lines 12 and 14. The clocked ROM of FIGURE 1 is therefore a less than optimum solution to the power dissipation problem suffered by static ROMs.

FIGURE 2 is a simplified electrical schematic diagram of a read-only memory array 40 according to the invention. For the sake of simplicity, only one word line 42 and two bit lines 44 and 46 are illustrated, it being understood that in an array formed in a large plurality of rows and columns, there will be provided one logical word line 42 for each row, and one bit line 44 or 46 for each column. The logical word line 42 preferably consists of two associated word line conductors, as will be described in more detail below.

Unlike the conventional clocked ROM, each memory cell according to the invention has a transistor formed therein, such as transistors 48 and 50. A gate 52 of the transistor 48 is connected to the word line 42. A first end 54 of the transistor 48 is connected to the bit line 44, while a second end 56 is connected to $V_{ss}$. A gate 58 of transistor 50 is connected to the word line 42, while a first end 60 of the current path of transistor 50 is connected to the bit line 46. A second end 62 of this current path is connected to $V_{dd}$.

Voltage sources $V_{dd}$ and $V_{ss}$ are used in the illustrated embodiment, but these can be replaced by any two voltage sources having voltages that are sufficiently separated from each other that different states will be sensed on bit lines 44 and 46. Also, the illustrated embodiment employs n-channel field effect transistors. It is however within the scope of the invention to use other types of transistors such as p-channel field effect transistors, or any type of transistor which can have a first end of its current path coupled to a bit line, a second line alternatively coupled to one of two voltage sources, and a control electrode coupled to a word line.

In operation, a high voltage is impressed on the word line 42, actuating the transistors 48 and 50. The bit line 44 will be brought to a low voltage, as the current path of transistor 48 has been actuated to connect the bit line 44 to $V_{ss}$. On the other hand, bit line 46 will be brought high by the connection of $V_{dd}$ to it by transistor 50. Hence, a logic "0" will be read on bit line 44, while a logic "1" will be read on bit line 46. The principal advantages of the invention may be seen in this operation: the clocking circuitry described in conjunction with FIGURE 1 is avoided, while at the same time the static dissipation of power usually associated with static ROMS is also avoided. Outside of charging the capacitances associated with the bit lines and word lines, power is dissipated only upon the actuation of a word line 42.

FIGURES 3a and 3b are highly magnified schematic sectional views of successive steps in a fabrication process for producing a single ROM cell 70 according to the invention. Referring particularly to FIGURE 3a, the cell 70 is preferably formed at a face 72 of a p-type semiconductor layer 74. The lateral limits of the cell 70 are indicated by dashed lines 75. A nitride layer 76 is first formed across the semiconductor face 72. The nitride layer 76 is then patterned and etched to leave the portions shown in FIGURE 3a. Next, a thick insulator layer 77, which for example may be oxide, is grown from those areas of the face 72 left exposed from the patterned and etched nitride layer 76.

Referring next to FIGURE 3b, the nitride layer 76 is stripped and a gate oxide or other insulator layer 78 is grown over the structure. Most of this growth will occur on the areas of face 72 exposed by the removal of the nitride layer 76, as shown; there may be slight additions (not shown) to the thickness of thick oxide layer 77.

In the next step, a layer of conductive material, such as highly doped amorphous or polycrystalline silicon or a metal, is deposited across the face of the structure. This conductive layer is patterned and etched to leave word line conductors 42a and 42b. Word line conductors 42a and 42b correspond to the word line conductor 42 of FIGURE 2. The word line conductor 42a defines a preselected programmed channel region 82.

Next, one or more implantation steps are used to implant an N-type dopant to form (N+) regions 54, 56 and 84. The lateral longitudinal margins (FIGURES 3 and 4) of bit line region 54 are self-aligned to the edge of conductor 42a on one side and to the edges of thick insulator layer 77 on the remaining sides. Voltage source region 84 is partially self-aligned to an opposite edge of the thick insulator layer 77. One edge of the voltage source region 56 is self-aligned to the other edge of the word line conductor 42a.

Referring to FIGURE 4, region 56 is preferably continuous with an (N+) implantation region that extends longitudinally parallel to conductor 42a. This implantation region is connected to ground or $V_{ss}$. In a like manner, the voltage source region 84 is continuous with an elongate, longitudinally-oriented implantation region 88 that is connected to the voltage source $V_{dd}$. In the illustrated embodiment, region 86 is continuous with other voltage source regions 56 of other memory cells 70 in the row, while elongate region 88 is continuous with other voltage source regions 84 in the same row of memory cells 70. In FIGURE 4, the lateral limits of one cell 70 are shown by a dashed rectangle 75. In a column direction, the cell 70 extends about half-way through the $V_{ss}$ region 86 on the one hand and about half-way through the $V_{dd}$ region 88 on the other.

Returning to FIGURE 3b, in the next step a further thick insulator layer 90 (omitted from FIGURE 4 for clarity) is deposited over the surface of the structure. A contact hole indicated generally at 92 is then opened in the thick insulator layer 90 and the gate insulator layer 78 to expose a portion of N+ region 54. The etching of opening 92 is followed by the deposition of a bit line conductor layer 44 such that hole 92 will be filled and the N+ bit line region will be contacted thereby. The lateral limits of the bit line conductor 44 are shown in FIGURE 4 by dashed lines 44. In a preferred embodiment, these are parallel to the limits 75 of cell 70 in a column direction.

FIGURES 3b and 4 illustrate a read-only memory cell 70 that has been preselected or "programmed" to represent a logic zero, as a transistor has been formed between bit line region 54 and $V_{ss}$ region 56 while no transistor has been formed between region 54 and $V_{dd}$ region 84. To represent a logic "1", the positioning (as shown in FIGURE 3b), of a portion of the thick insulator layer 77 is shifted from beneath the word line conductor 42b to beneath the word line conductor 42a. In this instance, a transistor will be formed between the bit line region 54 and the $V_{dd}$ region 84, while no transistor region will be formed between the bit line region 54 and the $V_{ss}$ region 56. The positioning of the word line conductors 42a and 42b are not altered at all, and may be linear and parallel to each other up and down a row of memory cells 70.

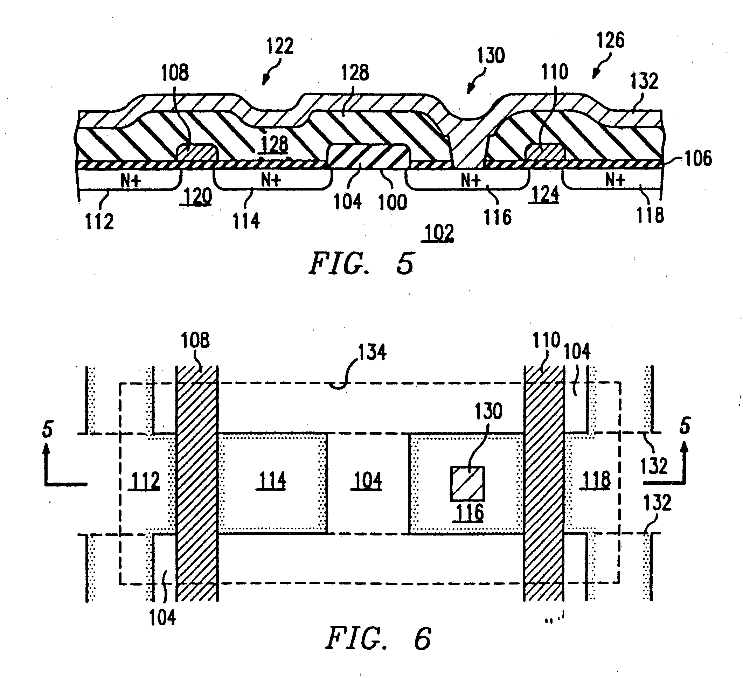

FIGURES 5 and 6 are highly magnified sectional and plan views, respectively, of an alternative physical embodiment of a ROM cell according to the invention that is contact-programmable. On a surface 100 of a (p-) type semiconductor layer 102, a nitride layer (not shown) is grown. This nitride layer is then patterned and etched to expose portions of the surface 100. A thick field oxide layer 104 is grown wherever the patterned and etched nitride layer (not shown) leaves the face 100 exposed. The nitride layer is then etched away.

Next, a gate oxide layer 106 is grown across the surface of the structure, with most of the growth occurring on the exposed regions of silicon not covered by the thick insulator layer 104. After this step, a highly doped layer of polycrystalline or amorphous silicon is deposited across the face of the structure and patterned and etched to leave a pair of polysilicon gates 108 and 110.

The thick oxide layer 104 and the polysilicon gates 108 and 110 are next used as masking structures for an implantation step that forms (n+) regions 112, 114, 116 and 118. Diffused region 112 is connected to a $V_{ss}$ voltage source, and corresponds to region 86 shown in FIGURES 3b and 4. Region 118 is connected to $V_{dd}$, and corresponds to the $V_{dd}$ region 88 of FIGURES 3b and 4. A first channel region 120 is defined underneath the gate 108 and between regions 112 and 114. A potential transistor indicated generally at 122 includes the drain region 114, the channel region 120, the source region 112 and the polysilicon gate 108.

A second channel region 124 is defined underneath the polysilicon gate 110 and between the drain region 118 and the source region 116. A potential transistor indicated generally at 126 includes the drain region 118, channel region 124, source region 116 and the polysilicon gate 110.

A thick insulator layer 128, such as oxide, is next deposited over the surface of the structure. A contact indicated generally at 130 is next opened through the insulator layer 128 to a preselected, programmed one of the regions 114 and 116. A metal bit line 132 is thereafter deposited, patterned and etched to substantially fill the contact 130 and to extend in a column direction across the structure.

FIGURE 6 is a schematic plan view corresponding to the sectional view of FIGURE 5. The thick insulator layer 128 and the gate oxide layer 106 have been omitted for the sake of clarity. The metal bit line 132 is represented by a pair of dashed horizontal lines. The boundary of this contact-programmable ROM cell is shown by the dashed enclosure 134.

As shown by FIGURES 5 and 6, the cell of this embodiment is programmed by choosing to which of two regions 114 and 116 a word line contact is made. If a contact 130 is made to the region 116 as shown, a transistor will be connected between $V_{dd}$ region 118 and the word line 132. If, on the other hand, a contact is made to the region 114, a transistor will be connected between the $V_{ss}$ region 112 and the bit line 132.

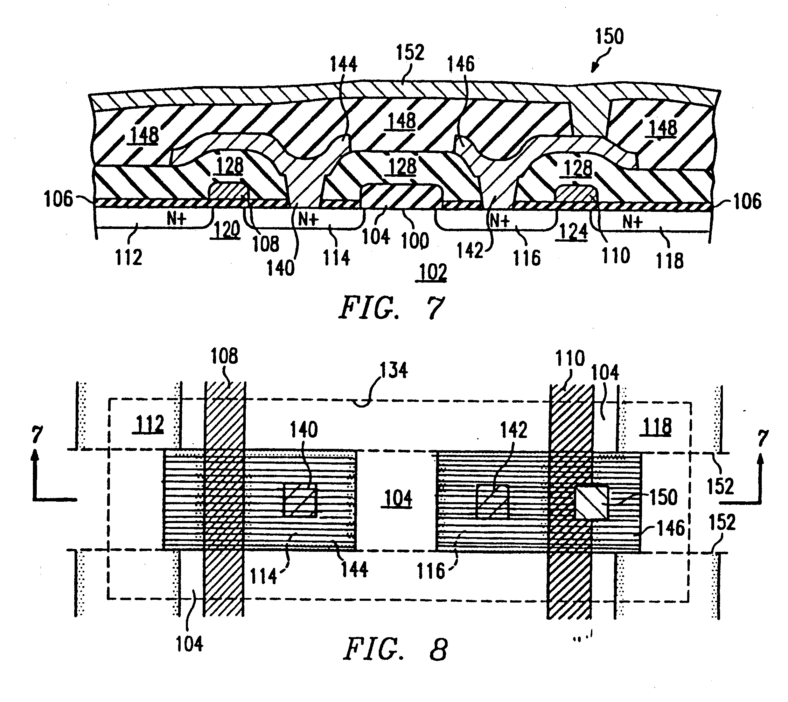

Yet another via-programmable embodiment of the invention is shown in FIGURES 7 and 8. FIGURE 7 is a highly magnified schematic sectional view of a via-programmable ROM cell. Since the contact-programmable cell shown in FIGURES 5 and 6 is similar in many respects to the via-programmable cell shown in FIGURES 7 and 8, like numbers identify like parts whereever possible throughout FIGURES 5-8.

The fabrication of the via-programmable cell is similar to that of the contact-programmable cell. The initial fabrication steps are virtually identical. The first difference in the fabrication process occurs when two contacts 140 and 142 are opened through the thick insulator layer 128 to the respective diffused regions 114 and 116. Then, a first metal layer is deposited, patterned and etched to form first metal straps 144 and 146. A second thick insulator layer 148 is deposited over the first thick insulator layer 128 and the straps 144 and 146. Then, a via indicated generally at 150 is opened to a preselected, programmed one of the straps 144 and 146 to program the cell. A second metal bit line conductor 152 is then deposited, patterned and etched to fill the via 150 and make contact to the strap 146 as well as to extend across the cell in a column direction.

A schematic plan view of the via-programmable cell is shown in FIGURE 8, with the insulator layers 106, 128 and 148 being omitted for clarity. The lateral limits of the cell are indicated by the dashed enclosure 134. The first metal straps 144 and 146 are indicated by horizontal shading. The metal 2 bit line 152 is represented by a pair of parallel dashed lines running in the row direction and covering the diffused regions 114 and 116.

As in the contact-programmable cell shown in FIGURES 5 and 6, two potential transistors are once again formed, the first including regions 112, 114 and 120 and gate 108, and the second including regions 116, 118, 124 and gate 110. This cell is programmed by making a connection to one of the regions 114 and 116 through a respective one of the intervening metal straps 144 and 146. Hence, a transistor will either be connected between $V_{dd}$ and the metal 2 word line 152 or another transistor will be connected between $V_{ss}$ and the word line 152.

In summary, a low-power dissipation static ROM cell and array has been shown and described that alternatively has formed therein a transistor between a bit line and $V_{ss}$ or between the bit line and $V_{dd}$.

While a preferred embodiment and its advantages have been described in conjunction with the above detailed description, the invention is not limited thereto but only by the scope and spirit of the appended claims.

## Claims

1. A read-only memory cell, comprising:
a transistor having a current path and a control electrode for controlling the conductance of said current path;
a word line coupled to said control electrode;
a bit line, a first end of said current path coupled to said bit line;
a first voltage source representative of a first bit value;
a second voltage source representative of a second bit value; and
a second end of said current path coupled to a preselected one of said first and second voltage sources, such that a selected one of said bit values may be read from said bit line when said current path is rendered conductive.

2. The memory cell of Claim 1, wherein said first voltage source comprises a drain voltage source, said second voltage source comprising a source voltage source.

3. The memory cell of Claim 1, wherein transistor comprises a field effect transistor, said current path comprising a channel region, said control electrode comprising a gate insulatively disposed adjacent said channel region for controlling the conductance thereof.

4. A read-only memory cell formed at a face of a semiconductor layer having a first conductivity type, comprising:
a bit line region formed in said semiconductor layer to be of a second conductivity type and having opposed lateral margins, said bit line region coupled to a bit line;
a channel region defined in said semiconductor layer adjacent a preselected programmed one of said lateral margins;
a voltage source region formed in said semiconductor layer to be of said second conductivity type, said channel region spacing said bit line region from said voltage source region, a voltage source representative of a preselected, programmed one of two bit values coupled to said voltage source region; and
a word line conductor insulatively disposed over said channel region such that a predetermined voltage thereon will render said channel region conductive.

5. The memory cell of Claim 4, wherein said voltage source region is coupled to said voltage source by a diffusion region of said second conductivity type formed continuously therewith.

6. A read-only memory array, comprising:
a plurality of transistors formed in rows and columns at an angle to said rows, each transistor having a current path and a control electrode;
for each row, a word line coupled to said control electrodes of the transistors in said row;
a bit line for each column, first ends of said current paths of respective transistors in said column coupled to said bit line;
a first voltage source representative of a first bit value, and a second voltage source representative of a second bit value; and
each current path having a second end, each second end coupled to a preselected, programmed one of said first and second voltage sources.

7. The memory array of Claim 14, wherein said first voltage source comprises a drain voltage, said second voltage source comprising a source voltage.

8. The memory array of Claim 14, wherein each of said transistors comprises a field effect transistor formed at a face of a semiconductor layer of a first conductivity type, each transistor comprising a bit line region formed at said face to be of a second conductivity type, a first voltage source region of said second conductivity type formed at said face and coupled to said first voltage source, a second voltage source region formed to be of said second conductivity type at said face and coupled to said second voltage source;
a first potential channel region disposed in said semiconductor layer between said bit line region and said first voltage source region, a second potential channel region disposed in said semiconductor layer between said bit line region and said second voltage source region; and
said bit line coupled to said bit line region, said control electrode comprising a word line conductor insulatively disposed over a preselected, programmed one of said potential channel regions, said preselected one of said potential channel regions forming said current path.

9. The memory array of Claim 16, wherein each of said plurality of transistors is disposed in a respective cell, said cells formed in said rows and columns;
a plurality of elongate word line conductor pairs insulatively disposed over said cells in a row direction such that each cell is intersected by one word line conductor pair, a respective word line conductor insulatively disposed over each said potential channel region;
one of said potential channel regions being deselected by disposing a thick insulator layer between said deselected potential channel region and a respective word line conductor, said preselected one of said potential channel regions being selected by disposing a thin gate insulator layer between said preselected potential channel region and said respective word line conductor.

10. The memory cell of Claim 17, wherein said first voltage source region, said bit line region and said second voltage source region are partially self-aligned by respective lateral margins of said thick insulator layer and the word line conductor associated with said preselected one of said potential channel regions.

11. The memory array of Claim 16, and further including a diffused region of said second conductivity type elongate in a row direction and continuous with said first voltage source region for coupling said first voltage source region to said first voltage source.

12. The memory array of Claim 16, and further comprising a diffused region of said second conductivity type elongate in a row direction and continuous with said second voltage source region for coupling said second voltage source region to said second voltage source.

13. A read-only memory cell, comprising:

a first transistor having a current path with first and second ends and a control electrode for controlling the conductance of said current path, said first end of said current path coupled to a source of a voltage representative of a first bit value;
a second transistor having a current path with first and second ends and a control electrode for controlling the conductance of the last said current path, said first end of the last said current path coupled to a source of a voltage representative of a second bit value;
a word line coupled to said control electrodes; and
a bit line coupled to a preselected, programmed one of said second ends such that a programmed one of said bit values may be read on said bit line when said current paths are rendered conductive.

14. A read-only memory cell formed at a face of a semiconductor layer having a first conductivity type, comprising:
spaced-apart first and second regions formed in said semiconductor layer to be of said second conductivity type;
a first voltage source region formed in said semiconductor layer to be of said second conductivity type and coupled to a source of a voltage representative of a first bit value, a first channel region defined at said face and of said first conductivity type spacing said first region from said first voltage source region, a first word line gate conductor insulatively disposed adjacent to said first channel region for selectively rendering said first channel region conductive;
a second voltage source region formed in said semiconductor layer to be of said second conductivity type and coupled to a source of a voltage representative of a second bit value, a second channel region defined at said face and of said first conductivity type spacing said second region from said second voltage region, a second word line conductor insulatively disposed adjacent to said second channel region for selectively rendering said second channel region conductive, said first and second voltage source regions spaced from each other; and
a bit line conductor coupled to a preselected, programmed one of said first and second regions such that a transistor is formed between said bit line conductor and a respective one of said voltage source regions.

15. The memory cell of Claim 22, and further comprising a thick insulator layer disposed outwardly adjacent said gate conductors, said voltage source regions and said first and second regions, said cell programmed by forming a contact orifice through said thick insulator layer to a preselected, programmed one of said first and second regions, said bit line conductor formed so as to substantially fill said contact orifice and contact said preselected one of said first and second regions.

16. The memory cell of Claim 22, and further comprising a first thick insulator layer disposed outwardly adjacent said gate conductors, said voltage source regions and said first and second regions;
contact orifices formed in said first thick insulator layer to expose respective portions of said first and second regions;
spaced-apart conductive straps formed over said first thick insulator layer and to fill respective ones of said orifices so as to contact respective ones of said first and second regions;
a second thick insulator layer formed over said first thick insulator layer and said conductive straps; and
a via orifice formed in said second thick insulator layer to a preselected, programmed one of said conductive straps, a word line conductor formed over said second thick insulator layer and in said via orifice to contact said selected one of said conductive straps.

17. A method for programming a read-only memory cell formed at a face of a semiconductor layer of a first conductivity type, comprising the steps of:
defining a cell at the face including a bit line region;
forming a thick insulator layer to be disposed outwardly from, and defining, a non-selected channel region of the cell, a first voltage source region of the cell spaced from the bit line region of the cell by the non-selected channel region;
forming a gate conductor to be insulatively disposed outwardly from, and defining, a selected channel region of the cell, a second voltage source region of the cell spaced from the bit line region by the selected channel region;
using the gate conductor and the thick insulator as masks, implanting exposed regions of the cell with a dopant of a second conductivity type, such that a transistor is formed between the second voltage source region and the bit line region but no transistor is formed between the first voltage source region and the bit line region;
coupling the second voltage source region to a source of voltage representative of a predetermined bit value; and
coupling the bit line region to a bit line.

18. The method of Claim 25, and further comprising the step of forming a diffused region in the semiconductor layer to be of the second conductivity type and continuous with the second voltage source region to couple the second voltage source region to the source of voltage.

19. A method for programming a read-only memory cell, comprising the steps of:
defining a cell at a face of a semiconductor layer to be of a first conductivity type;

defining the placement of a pair of elongate spaced-apart parallel word line conductors to cross the cell, a first potential channel region associated with a first of the word line conductors, a second potential channel region associated with a second of the word line conductors;

deselecting one of the potential channel regions by forming a thick insulator layer thereacross;

selecting a remaining one of the potential channel regions by not forming the thick insulator layer thereacross;

growing a gate insulator layer on the face;

forming the word line conductor pair according to their defined placement; and

implanting exposed areas of the cell with a dopant of the second conductivity type using the thick insulator layer and the one of said word line conductors not associated with the thick insulator layer as a mask, such that a transistor will be formed around the selected potential channel region.

20. A method for programming an array of read-only memory cells, comprising the steps of:

for each cell, coupling one end of a transistor of the cell to one of a plurality of bit line conductors of the array;

in each cell representing a first logic state, forming a transistor current path between the transistor end and a first voltage source;

in each cell representing a second logic state, forming a transistor current path between the transistor end and a second voltage source; and

for each cell, forming a control electrode to control the conductance of the current path of the transistor; and

coupling each of the control electrodes to one of a plurality of word lines of the array.

21. A method for programming a read-only memory cell, comprising the steps of:

forming a first transistor such that one end of a current path thereof is coupled to a first voltage source representative of a first bit value;

forming a second transistor such that a first end of a current path thereof is coupled to a second voltage source representative of a second bit value;

coupling control electrodes of said first and second transistors to a word line for selectively rendering the current paths of said transistors conductive; and

coupling a preselected, programmed one of a pair of second ends of respective current paths of said first and second transistors to a bit line, such that a preselected one of the first and second transistors selectively couples the bit line to a preselected one of the first and second voltage sources.

FIG. 1 (PRIOR ART)

FIG. 2

FIG. 3a

FIG. 3b

FIG. 4

FIG. 5

FIG. 6

EP 0 376 568 A2

FIG. 7

FIG. 8